# FASCICULE DE BREVET EUROPEEN

(11) **EP 2 715 808 B1**
(45) Date de publication et mention de la délivrance du brevet: **25.07.2018**
(21) Numéro de dépôt: 12726070.1
(22) Date de dépôt: 29.05.2012
(51) Int. Cl.: H01L 33/06, H01L 33/38, H01L 33/08, H01L 33/18

(54) **STRUCTURE SEMICONDUCTRICE DESTINÉE À ÉMETTRE DE LA LUMIÈRE ET PROCÉDÉ DE FABRICATION D'UNE TELLE STRUCTURE**
HALBLEITERSTRUKTUR ZUR AUSSTRAHLUNG VON LICHT UND VERFAHREN ZUR HERSTELLUNG EINER SOLCHEN STRUKTUR
SEMICONDUCTOR STRUCTURE FOR EMITTING LIGHT, AND METHOD FOR MANUFACTURING SUCH A STRUCTURE

(30) Priorité: 01.06.2011 FR 1154844
(43) Date de publication de la demande: 09.04.2014
(73) Titulaire: Commissariat à l'Énergie Atomique et aux Énergies Alternatives, 75015 Paris (FR)
(72) Inventeur: ROBIN, Ivan-Christophe, F-38000 Grenoble (FR)
(74) Mandataire: Ahner, Philippe
(86) Numéro de dépôt international: PCT/EP2012/060011
(87) Numéro de publication internationale: WO 2012/163899

(56) Documents cités:
- EP-A1- 1 791 186
- WO-A1-2009/128777
- WO-A1-2010/071594
- FR-A1- 2 934 716

## Description

### DOMAINE TECHNIQUE

L'invention se rapporte au domaine de la fourniture de moyens d'émission de lumière et plus particulièrement au domaine de la fourniture de moyens d'émission de lumière dans la gamme des ultra-violets (acronyme UV).

Durant ces vingt dernières années, l'industrie des semiconducteurs a démontré et développé le fort potentiel des structures semiconductrices pour l'émission de lumière dans les gammes de longueurs d'ondes allant de la gamme des infrarouges au visible.

En raison de limites technologiques liées aux matériaux semiconducteurs, le potentiel des structures semiconductrices pour l'émission de lumière dans les longueurs d'ondes allant du proche UV aux UV profonds reste encore à démontrer.

L'invention concerne plus particulièrement une structure semiconductrice destinée à émettre de la lumière et au procédé de fabrication d'une telle structure semiconductrice.

### ÉTAT DE LA TECHNIQUE ANTÉRIEURE

Ces dernières années différentes pistes ont été explorées dans le but de développer des structures semiconductrices destinées à émettre de la lumière dans les gammes de longueurs d'ondes des UV.

Une première piste concerne des structures semiconductrices basées sur une jonction semiconductrice (généralement connue sous la dénomination jonction p-n) à base de semiconducteurs grand gap à gap direct, tels que l'oxyde de zinc (ZnO), le nitrure de gallium (GaN). En effet, selon un principe, identique à celui utilisé pour la réalisation de structures semiconductrices destinées à émettre de la lumière dans les longueurs d'ondes du visible, le ménagement d'une zone favorable à la recombinaison de paires électron-trou dans une jonction semiconductrice polarisée en direct d'un matériau grand gap à gap direct doit permettre une émission de photons dans les longueurs d'ondes des UV. Ainsi pour une jonction à base de ZnO [1], dont le gap est d'une valeur de 3,37eV, il est possible d'atteindre une longueur d'onde d'environ 370nm.

Néanmoins, l'exploitation de ce type de jonction semiconductice reste limitée par les problèmes de dopage existant pour les matériaux semiconducteurs à grand gap. En effet, l'énergie d'activation des dopants de tels matériaux est souvent du même ordre de grandeur ou d'une valeur supérieure à l'énergie thermique à la température ambiante pour au moins l'un des deux types conductivités.

En réponse à ce problème et selon un principe similaire, l'utilisation d'hétérojonctions [2] a également été envisagée. Néanmoins ce type d'hétérojonctions présente une problématique liée à la qualité d'interface d'une telle hétérojonction, les défauts d'interface créant des pièges recombinants non radiatifs qui limitent le rendement d'émission des structures semiconductrices présentant une telle hétérojonction.

Pour contourner cette limite, J. Simon et ses collaborateurs ont récemment proposé [3] d'utiliser un champ électrique interne à la structure semiconductrice pour injecter des porteurs minoritaires au niveau de l'une des deux zones formant la jonction. Dans ces travaux, le champ électrique est généré par l'utilisation combinée de la différence de gap entre le Nitrure de gallium aluminium (AlGaN) et le nitrure de gallium (GaN), et d'une gradation de la composition en aluminium au niveau de la jonction. Le champ électrique ainsi généré permet l'injection de porteurs minoritaires qui favorise en retour les recombinaisons électron-trou à l'origine de l'émission de lumière. De même, cette gradation permet de limiter les défauts d'interface liés à l'hétérojonction, cette interface étant graduelle.

Si ces travaux montrent le fort potentiel de l'injection de porteurs liée à un champ électrique, la faisabilité industrielle reste à démontrer.

Une autre solution, décrite dans le brevet français FR 2934716, consiste à générer un champ électrique externe pour obtenir une zone d'inversion du type de porteur dans l'une des deux zones de la jonction. Cette inversion de porteurs est obtenue par l'utilisation d'une grille de polarisation de la zone à inverser qui est adaptée pour que sa polarisation entraîne une injection de porteurs majoritaires de l'autre zone dans ladite zone. Une telle inversion de porteurs permet de créer dans cette même zone une région propice à la recombinaison de porteurs et donc à l'émission de lumière, cette région formant une « quasi-jonction » semiconductrice. Il en résulte ainsi que même pour un faible dopage de la zone non inversée, la région propice à l'émission n'est limitée que par la zone polarisée. De plus cette région peut être, par la polarisation, éloignée de la jonction et des pièges recombinant non radiatifs qui peuvent s'y trouver dans le cas d'une hétérojonction.

On entend ci-dessus par quasi-jonction, une jonction semiconductrice formée par la création dans un matériau présentant un seul type de conductivité d'une zone d'un type de conductivité opposé ceci, par exemple, par injection de porteurs minoritaires dans ladite zone.

Néanmoins, avec la configuration planaire proposée dans ledit brevet, la région émettrice reste limitée par les zones polarisées par la grille, elle-même limitée par la géométrie de l'anode et la cathode, et ne permet donc pas d'obtenir une grande surface d'émission et donc une grande puissance d'émission sans combiner un grand nombre de structures semiconductrices entre elles.

WO 2009/128777 A1 divulgue une structure semiconductrice à nanofils comportant un moyen de polarisation pour inverser le type de porteurs dans une partie des nanofils.

### EXPOSÉ DE L'INVENTION

L'un des buts de l'invention est de fournir une structure semiconductrice destinée à émettre de la lumière avec utilisation d'un champ électrique externe à la jonction pour injecter des porteurs minoritaires dans une partie de la structure semiconductrice et ainsi en inverser au moins partiellement le type de conductivité, ladite structure présentant une configuration permettant une optimisation de l'injection de porteurs minoritaires dans ladite partie de manière à permettre une amélioration du rendement d'émission par rapport à un agencement de l'art antérieur.

L'invention à plus précisément pour but de fournir une structure semiconductrice destinée à émettre de la lumière et qui comporte une première et une deuxième partie en contact l'une de l'autre de manière à former une jonction semiconductrice, ladite jonction étant inadaptée pour émettre de la lumière de façon efficace, ceci en raison de problèmes liés à la technique de dopage du ou des matériaux constituant la structure ou d'une forte concentration en défauts cristallins au niveau de ladite jonction, ladite structure comportant en outre un moyen de polarisation adapté pour inverser le type de porteurs dans l'une des parties par injection dans ladite partie de porteurs majoritaires de l'autre partie, ceci de manière à déplacer la jonction dans ladite partie, ladite structure étant configurée de manière à présenter une surface d'émission supérieure à une structure antérieure comportant un tel moyen de polarisation.

A cet effet l'invention concerne une structure semiconductrice adaptée pour émettre de la lumière comportant :
- un substrat réalisé en un premier matériau semiconducteur présentant un premier type de conductivité, le substrat présentant une première et une seconde face,
- un premier contact électrique sur la première face,
- au moins un deuxième matériau semiconducteur, présentant un second type de conductivité formant une première partie de la structure semiconductrice et en contact électrique avec une deuxième partie de la structure semiconductrice présentant la première conductivité de manière à former une jonction,
- un second contact électrique connecté électriquement avec le deuxième matériau semiconducteur,
- un moyen de polarisation adapté pour polariser au moins une partie de la structure semiconductrice parmi la première et la deuxième partie, le moyen de polarisation étant agencé de manière à ce que sa polarisation entraîne une inversion du type de porteurs dans ladite partie par injection dans ladite partie de porteurs majoritaires de l'autre partie, ceci de manière à déplacer la jonction dans ladite partie,
la structure semiconductrice comportant :
- une pluralité de micro- ou nano-structures semiconductrices présentant chacune une première et une seconde extrémité, chacune des premières extrémités étant reliée à la seconde face, chaque micro- ou nano- structure comportant au moins une portion réalisée dans le deuxième matériau semiconducteur de manière à former la première partie, ou chaque micro- ou nano- structure présentant la première conductivité avec la seconde extrémité en contact avec le deuxième matériau semiconducteur, ceci de manière à former la jonction,
et chaque micro- ou nano- structure comporte une part de ladite micro- ou nano- structure dont le type de porteurs est destiné a être inversé par le moyen de polarisation.

On entend ci-dessus, et dans la reste de ce document, par un premier type de conductivité et un second type de conductivité des conductivités correspondant à respectivement un premier type de porteurs majoritaires pouvant être choisi dans le groupe comportant les électrons et les trous, et à un second type de porteurs majoritaires différent choisi dans ce même groupe.

On entend ci-dessus et dans le reste de ce document par jonction semiconductrice, une zone de transition entre des régions semi-conductrices de propriétés électriques différentes, une telle zone étant caractérisée par l'existence d'une barrière de potentiel.Une telle structure semiconductrice permet une inversion du type de porteurs au niveau de la seconde face et/ou de la pluralité de nanostructure ceci de façon 3D, puisque chaque micro- ou nanostructure présente au moins une partie de la première et de deuxième partie de la structure formant la jonction, augmentant ainsi significativement la zone dans laquelle le type de porteurs est inversé et donc dans laquelle les recombinaisons des paires électron-trou peuvent avoir lieu. En effet, lorsque le moyen de polarisation est polarisé, la « quasi-jonction » est donc formée dans au moins une partie de chacune des micro- ou nano- structures et peut, selon la configuration s'étendre également le long de la seconde face du substrat. Avec une telle « quasi-jonction » on optimise ainsi les zones dans lesquelles les recombinaisons paires électron-trou radiatives peuvent avoir lieu et donc les zones d'émission de lumière.

Le moyen de polarisation peut comporter une couche d'isolant en contact avec la partie de la structure semiconductrice à polariser et une couche conductrice sur ladite couche d'isolant.

Une telle couche d'isolant sur laquelle est déposée une couche conductrice permet de fournir un moyen de polarisation d'au moins une partie de la structure semiconductrice homogène puisque fourni par une couche conductrice présente sur une couche d'isolant en contact avec ladite partie de la structure semiconductrice.

La couche d'isolant peut être en contact avec les zones de la seconde face laissées libres par les micro- ou nano- structures et sur au moins une portion de chaque micro- ou nano- structure.

Une telle couche d'isolant peut permettre une polarisation de l'ensemble de la partie de la structure semiconductrice à polariser sans risque de court-circuit, la couche conductrice pouvant être déposée sur cette couche d'isolant sans risque de court-circuit avec la dite partie de la structure semiconductrice.

Un tel arrangement de la couche d'isolant permet également, avec une configuration des micro- et nano- structures adéquate, une polarisation de la partie dont le type de porteurs est non inversé, facilitant ainsi l'injection des porteurs minoritaires dans la partie à inverser.

La couche conductrice peut être adaptée pour être au moins partiellement transparente à la longueur d'onde à laquelle la structure semiconductrice est destinée à émettre.

Ainsi, la lumière émisse peut être transmise au travers de la couche conductrice.

La couche conductrice peut être avantageusement de l'oxyde d'indium-étain (ITO), un métal de faible épaisseur de manière à le rendre au moins partiellement transparent à la longueur d'onde d'émission de la structure semiconductrice ou un semiconducteur transparent à la longueur d'onde d'émission de la structure semiconductrice et présentant un fort dopage de manière à le rendre dégénéré et donc conducteur.

La couche d'isolant peut être réalisée dans un matériau sélectionné dans le groupe comportant le dioxyde de silicium (SiO₂) et les diélectriques "High-k", tels que le dioxyde d'hafnium (HfO₂).

Le dépôt de tels matériaux étant parfaitement maîtrisé dans l'industrie des semiconducteurs à base de silicium, ces matériaux permettent de fournir une couche isolante présentant l'isolation nécessaire pour la polarisation de la zone à inverser sans présenter les risques de fuites inhérents à une couche d'isolant non maîtrisée.

Chaque micro- ou nano- structure peut présenter au moins une dimension réduite selon l'une des directions sensiblement parallèles à la seconde face de manière à former une micro- ou nano- structure 2D, préférentiellement 1D.

On entend par micro- ou nano- structure 2D, ou 1D, une micro- ou nano- structure dont une dimension, ou deux dimensions, est inférieure ou du même ordre de grandeur que le libre parcourt moyen électronique correspondant du ou aux matériaux composant ladite micro- ou nano- structure

Une telle dimension réduite permet à la fois un confinement quantique et une optimisation de la région du substrat qui est influencée par l'inversion du type de porteurs, ceci tout en limitant les zones d'ombrage liées à la présence des micro- ou nano-structures, ces zones d'ombrages ne l'étant que sur cette dimension réduite.

Chaque micro ou nano- structure peut être un nanofil semiconducteur.

De telles micro- ou nano- structures peuvent être facilement obtenues en une seule fois par croissance épitaxiale sur toute la surface substrat, limitant ainsi le nombre d'étape de fabrication et donc les coûts de fourniture d'une structure semiconductrice selon l'invention.

Selon un premier mode réalisation, chaque micro- ou nano- structure peut présenter une conductivité du même type que celle du premier matériau semiconducteur de manière à former la deuxième partie, la seconde extrémité de chacune des micro- ou nano-structures étant en contact avec le deuxième matériau semiconducteur.

De telles micro- ou nano- structures peuvent être obtenues en une seule étape de croissance, limitant ainsi les étapes nécessaires pour la fourniture d'une structure semiconductrice selon l'invention.

Selon un autre mode de réalisation chaque micro ou nano- structure peut présenter :
- une première portion comportant la première extrémité, et présentant une conductivité du même type que celle du premier matériau semiconducteur de manière à former la deuxième partie, et
- une seconde portion comportant la seconde extrémité, et étant réalisée dans le deuxième matériau semiconducteur de manière à former la première partie.

Une telle configuration de chacune des micro- ou nano- structures permet de fournir une structure semiconductrice présentant la jonction au niveau des micro- ou nano- structures permettant ainsi, pour un moyen de polarisation adapté, de polariser à la fois la portion à inversée et la portion non inversée de chacune des micro- ou nano- structures. En effet, une telle configuration permet l'optimisation de l'injection des porteurs minoritaires dans la zone à inverser.

Selon une autre forme de réalisation, chaque micro- ou nano- structure peut être entièrement réalisée dans le deuxième matériau semiconducteur de manière à former la première partie.

Ainsi la structure présente la jonction au plus proche de la surface du substrat permettant ainsi une inversion du type de porteurs optimisée au niveau de la seconde face.

Chaque micro- ou nano- structure peut comporter une fraction d'une couche dite de mouillage en contact avec le substrat, cette fraction de la couche de mouillage formant la première extrémité de ladite micro- ou nano- structure.

Avec une telle couche de mouillage, la partie à inverser est formée par les micro- ou nano-structures, l'inversion du type de porteurs peut donc avoir lieu sur l'ensemble de chacune des micro- ou nano- structures, la couche de mouillage comprise.

Selon une possibilité de l'invention, au moins une portion du nanofil peut comporter une conformation du type « coeur-coquille », c'est-à-dire que la portion du nanofil est constituée d'au moins deux matériaux semiconducteurs, l'un, dit matériau coeur, formant le centre de ladite portion du nanofil et l'autre, dit matériau coquille, entourant le matériau coeur de manière à former le contour extérieur de la portion de nanofil.

Une telle conformation permet à une portion de nanofil, préférentiellement choisie comme celle étant comprise dans la partie à inversée de la structure semiconductrice, de présenter un meilleur confinement quantique dans le matériau coeur avec une interface entre le matériau coeur et le matériau coquille présentant une faible densité de pièges non radiatif, augmentant ainsi le rendement d'émission d'un tel nanofil.

Le nanofil peut présenter une seule portion de nanofil comportant une conformation « coeur-coquille », ladite portion de nanofil étant une portion sélectionnée dans le groupe comportant la première portion et la seconde portion.

La jonction peut être une hétérojonction.

Une telle jonction permet d'utiliser les qualités d'un matériau semiconducteur présentant un gap adéquat pour émettre à la longueur d'onde choisie sans nécessiter que ce même matériau ait la possibilité de présenter les deux types de conductivité pour former la jonction.

La partie de la structure semiconductrice de la première et de la seconde partie présentant une conductivité dont les porteurs majoritaires sont des électrons peut être réalisée dans un matériau semiconducteur présentant un dopage de type n, ledit matériau semiconducteur étant préférentiellement sélectionné dans le groupe comportant l'oxyde de zinc (ZnO), l'oxyde de zinc manganèse (ZnMgO), le nitrure de gallium (GaN), le nitrure de gallium-aluminium (AlGaN).

De tels matériaux semiconducteurs permettent, par l'énergie de leur bande interdite et le fait qu'ils présentent un gap direct, une émission dans la gamme des UV.

La partie de la structure semiconductrice de la première et de la seconde partie présentant une conductivité dont les porteurs majoritaires sont des trous peut être réalisée dans un matériau semiconducteur présentant un dopage de type p, ledit matériau semiconducteur étant préférentiellement sélectionné dans le groupe comportant le nitrure de gallium (GaN), le séléniure de zinc (ZnSe) et le tellurure de zinc (ZnTe).

De tels matériaux semiconducteurs permettent, par l'énergie de leur bande interdite et le fait qu'ils présentent un gap direct, une émission dans la gamme des UV.

L'invention se rapport également à un Procédé de fabrication d'une structure semiconductrice selon l'invention, ledit procédé de fabrication comportant les étapes consistant à :
- fournir un substrat réalisé dans un premier matériau semiconducteur présentant un premier type de conductivité, ledit substrat présentant une première et une seconde face
- réaliser un premier contact électrique sur la première face,
- former une pluralité de micro- ou nano-structures sur la seconde face, chacune des micro- ou nano- structures présentant une première et une seconde extrémité avec chacune des premières extrémités connectée à la seconde face, chaque micro- ou nano-structures comportant au moins une portion réalisée dans un deuxième matériau semiconducteur présentant, ou à même de présenter par l'action d'un matériau dopant, une conductivité d'un deuxième type de manière à former une première partie de la structure semiconductrice avec le substrat et/ou une autre portion de chacune des micro- ou nano- structures formant une deuxième partie de la structure semiconductrice, ou chaque micro- ou nano- structure présentant le premier type de conductivité et formant au moins partiellement une deuxième partie de la structure semiconductrice,

- former un moyen de polarisation adapté pour polariser au moins une partie parmi la première et la deuxième partie, le moyen de polarisation étant agencé de manière à ce que sa polarisation entraîne une inversion du type de porteurs dans ladite partie,
- déposer, si chaque micro- ou nanostructure présente le premier type de conductivité et forme au moins partiellement la deuxième partie de la stucture, un deuxième matériau semiconducteur de manière à former une première partie de la structure semiconductrice,
- réaliser un second contact électrique en contact avec le deuxième matériau semiconducteur.

Un tel procédé permet la formation d'une structure semiconductrice apte à émettre de façon optimisée de la lumière dans des longueurs d'onde des UV, le contact entre la première et la seconde partie permettant la formation de la jonction.

Selon une possibilité de l'invention le procédé peut être un procédé de fabrication d'une structure semiconductrice dont le moyen de polarisation comporte une couche d'isolant en contact avec la partie de la structure semiconductrice à polariser et une couche conductrice sur ladite couche d'isolant, l'étape consistant à former un moyen de polarisation comportant les étapes consistant à:
- déposer une couche d'isolant sur les zones de la seconde face laissées libres par les micro- ou nano- structures et sur au moins une portion des micro- ou nano- structures,
- déposer une couche conductrice sur la couche d'isolant.

Un tel procédé permet de fournir une structure semiconductrice avec un moyen de polarisation fournissant une polarisation homogène sur toute la partie de la structure semiconductrice à polariser.

Le procédé peut comprendre après l'étape consistant à former un moyen de polarisation et avant l'étape consistant à réaliser le second contact électrique, les étapes consistant à en outre :
- Supprimer la part de la couche d'isolant et de la couche conductrices présent sur chacune des micro- ou nano- structure au niveau de leur seconde extrémité et au moins au niveau du pourtour à proximité de la seconde extrémité sur chacune des micro- ou nano-structures,
- déposer un matériau de remplissage de manière à ce que l'espace entre les micro- ou nano-structures soit au moins partiellement rempli et que chacune des micro- ou nano- structures présente au moins une portion recouverte.

De tels étapes permettent le dépôt d'un matériau de remplissage, ce matériau de remplissage permettant la fourniture d'un support pour le dépôt d'un autre matériau, tel qu'un matériau dopant ou le deuxième matériau semiconducteur.

Selon une possibilité de l'invention le dépôt de matériau de remplissage peut être réalisé de manière à ce que l'espace entre les micro- ou nano-structures soit totalement rempli, la seconde extrémité de chacune des micro- ou nano- structures affleurant du matériau de remplissage.

Selon une variante de l'invention, le procédé de fabrication peut être pour la fabrication d'une structure semiconductrice dans laquelle chaque micro ou nano- structure présente :
- une première portion comportant la première extrémité, et présentant une conductivité du même type que celle du premier matériau semiconducteur de manière à former la deuxième partie,
- une seconde portion comportant la seconde extrémité, et étant réalisée dans le deuxième matériau semiconducteur de manière à former la première partie,
le procédé comprenant, après l'étape consistant à former un moyen de polarisation et avant l'étape consistant à réaliser le second contact électrique, les étapes consistant à:
- déposer une couche de remplissage de manière que l'espace entre les micro- ou nanostructure soit rempli et de manière qu'une première portion de chacune des micro- ou nano- structures soit recouverte et qu'une seconde portion de chacune des micro- ou nano- structures dépasse de ladite couche de remplissage,
- supprimer la part de la couche conductrice et de la couche isolante de la deuxième partie de chacune des micro- ou nano- structures,
- déposer une couche de matériau dopant, tel qu'un polymère contenant des ions dopants, ladite couche étant déposée de manière à ce que la seconde extrémité de chacune des micro- ou nano- structures soit affleurante,
- effectuer une activation de la couche de matériau dopant de manière à permettre le dopage de la deuxième portion de chacune des micro- ou nano-structures.

De telles étapes permettent la fourniture d'une structure dont au moins une portion de chacune des micro- ou nano- structures est dopée par un matériau dopant.

### BRÈVE DESCRIPTION DES DESSINS

La présente invention sera mieux comprise à la lecture de la description d'exemples de réalisation, donnés à titre purement indicatif et nullement limitatif, en faisant référence aux dessins annexés sur lesquels :
- la figure 1 illustre un premier mode de réalisation d'une structure semiconductrice selon l'invention, ladite structure semiconductrice comportant des nanofils présentant le même type de conductivité que le substrat,
- les figures 2 a) à d) illustrent le procédé de fabrication et d'émission d'une structure semiconductrice selon le premier mode de réalisation,
- la figure 3 illustre un deuxième mode de réalisation d'une structure semiconductrice selon l'invention, ladite structure semiconductrice comportant des nanofils présentant une conductivité d'un autre type que celui du substrat,
- les figures 4 a) à d) illustrent le procédé de fabrication et d'émission d'une structure semiconductrice selon le deuxième mode de réalisation,
- la figure 5 illustre un troisième mode de réalisation d'une structure semiconductrice selon l'invention, ladite structure semiconductrice comportant des nanofils présentant une première portion d'un premier type de conductivité et une portion d'un second type de conductivité, la grille étant présente sur toute la longueur des nanofils ,
- les figures 6 a) à d) illustrent un procédé de fabrication et d'émission d'une structure semiconductrice selon le troisième mode de réalisation,
- la figure 7, illustre un quatrième mode de réalisation d'une structure semiconductrice selon l'invention, ladite structure semiconductrice comportant des nanofils présentant une première portion d'un premier type de conductivité et une portion d'un second type de conductivité, la grille étant présente sur une seule portion du nanofil,
- les figures 8 a) à e) illustrent un procédé de fabrication et d'émission d'une structure semiconductrice selon le quatrième mode de réalisation,
- la figure 9 illustre un cinquième mode de réalisation selon l'invention, ladite structure semiconductrice comportant des nanofils comportant chacun une portion de couche de mouillage et présentant une conductivité d'un autre type que celui du substrat,
- les figures 10 a) à d) illustrent un procédé de fabrication et d'émission d'une structure semiconductrice selon le cinquième mode de réalisation,
- Les figures 11 a) à c) illustrent des variantes de réalisation d'une structure semiconductrice selon l'invention, la structure semiconductrice selon ces variantes de réalisation comportant des nanofils présentant au moins une portion de nanofil de type « coeur-coquille »,

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

### EXPOSÉ DÉTAILLÉ DE MODES DE RÉALISATION PARTICULIERS

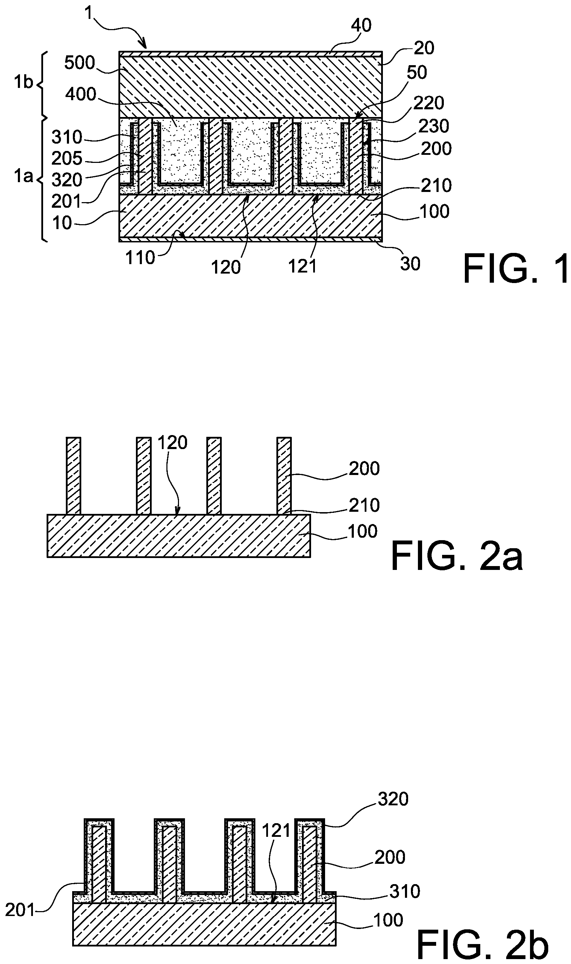

La figure 1 est une vue schématique en coupe transversale illustrant un premier mode de réalisation d'une structure semiconductrice 1 selon l'invention.

Une telle structure semiconductrice 1 est une structure semiconductrice 1 destinée à émettre de la lumière. Une telle structure semiconductrice 1 est plus particulièrement adaptée pour émettre dans les longueurs d'onde du proche UV et de l'UV profond.

Une structure semiconductrice selon ce premier mode de réalisation 1 comporte :
- un substrat semiconducteur 100 réalisé en un premier matériau semiconducteur 10 présentant une conductivité dont les porteurs majoritaires sont des électrons, c'est-à-dire de type n, le substrat semiconducteur 100 présentant une première et une seconde face 110, 120,
- un premier contact électrique 30 sur la première face 110,
- une pluralité de nanofils 200 connectés à la seconde face 120, lesdits nanofils 200 présentant le même type de conductivité que le substrat semiconducteur 100, chacun des nanofils 200 comportant une première et seconde extrémité 210, 220,
- une couche d'isolant 310 en contact avec les zones 121 de la seconde face 120 laissées libres par les nanofils 200 et avec une partie du pourtour 230 des nanofils 200,
- une couche de métal 320 en contact avec la couche d'isolant 310 et sans contact avec les nanofils 200,
- un matériau de remplissage 400 remplissant l'espace entre les nanofils 200,
- une couche 500 d'un deuxième matériau semiconducteur 20 présentant une conductivité dont les porteurs majoritaires sont des trous, c'est-à-dire de type p, ladite couche 500 étant en contact avec la seconde extrémité 220 de chacun des nanofils 200 de manière à former une jonction semiconductrice 50,
- un second contact électrique 40 en contact avec la couche 500 du deuxième matériau semiconducteur 20.

Le substrat 100 est un substrat semiconducteur classiquement utilisé pour la réalisation de structures émettrices et pouvant présenter une conduction de type n.

Pour les applications envisagées, le premier matériau semiconducteur 10 formant le substrat semiconducteur 100 est préférentiellement un semiconducteur dit grand gap. On entend par grand gap que le matériau semiconducteur présente une énergie de bande interdite supérieure à 1,5eV.

Ainsi le premier matériau semiconducteur 10 peut être du nitrure de gallium (GaN), du nitrure de gallium-aluminium (AlGaN) ou encore de l'arséniure de gallium (GaAs). De manière à ce que le substrat semiconducteur 100 présente la conductivité n, le premier matériau semiconducteur 10 est dopé n.

Le premier contact électrique 30 est préférentiellement un contact électrique de type n de manière à limiter la résistance électrique avec le premier matériau semiconducteur 10.

Les nanofils 200 sont connectés au substrat semiconducteur 100 sur la seconde face 120. Chaque nanofil 200 présente sa première extrémité 210 en contact avec la seconde face 120.

Chacun des nanofils 200 est réalisé dans un matériau semiconducteur 201 grand gap à gap direct présentant un dopage de type n. On entend par matériau semiconducteur à gap direct un semiconducteur dont le maximum d'énergie de la bande de valence et le minimum d'énergie de la bande de conduction se situent à une valeur du vecteur d'onde k sensiblement également dans le diagramme de dispersion énergétique dudit matériau semiconducteur.

Le matériau semiconducteur 201 dans lequel sont réalisés les nanofils 200 est adapté à la longueur d'onde d'émission souhaitée de la structure semiconductrice 1. Ainsi pour une émission de lumière dans la gamme des longueurs d'ondes proches UV, le matériau semiconducteur 201 formant les nanofils 200 peut être de l'oxyde de zinc (ZnO) ou du nitrure de gallium (GaN). Pour une émission dans la gamme des UV profond, le matériau semiconducteur 201 formant les nanofils 200 peut être l'oxyde de zinc manganèse (ZnMgO) ou du nitrure de gallium-aluminium (AlGaN).

Selon une possibilité de l'invention le matériau semiconducteur 201 dans lequel sont réalisés les nanofils 200 peut être avantageusement le même que le premier matériau semiconducteur 10.

Les nanofils 200 ont préférentiellement un diamètre compris entre 5nm et 1µm pour une longueur comprise entre 50nm et 10µm.

Les nanofils 200 forment avec la seconde face 120 une deuxième partie la de la structure semiconductrice 1.

La couche de matériau isolant 310 recouvre à la fois les zones 121 de la seconde face 120 laissées libres par les nanofils 200 et une partie du pourtour 230 des nanofils 200 en laissant libre la seconde extrémité 220 de chacun des nanofils 200. Le matériau isolant formant la couche de matériau isolant 310 peut être le dioxyde de silicium (SiO₂), et les diélectriques « high k », tels que le dioxyde d'hafnium (HfO₂), par exemple. On entend par diélectrique « high k » un diélectrique possédant une constante diélectrique plus élevée que celle du dioxyde de silicium. La couche de matériau isolant présente une épaisseur comprise entre 5nmm et 50nm.

La couche conductrice 320 est préférentiellement adaptée pour être transparente à la longueur d'onde d'émission de la structure semiconductrice 1. Ainsi la couche conductrice 320 peut être une couche d'oxyde d'indium-étain (également connu sous l'acronyme ITO) ou tout autre matériau conducteur et transparent connu de l'homme du métier.

La couche conductrice 320 et la couche de matériau isolant 310 forment un moyen de polarisation agencé de manière à ce que sa polarisation entraîne une inversion du type de porteurs dans ladite partie (la, 1b) par injection dans ladite partie (la, 1b) de porteurs majoritaires de l'autre partie (1b, 1a), ceci de manière à déplacer la jonction dans ladite partie,

Le matériau de remplissage 400 peut être un matériau diélectrique, tel que du dioxyde de silicium ou un matériau diélectrique « low k ». On entend par diélectrique « low k » un diélectrique possédant une constante diélectrique plus faible que celle du dioxyde de silicium. Ce matériau de remplissage 400 peut être, pour faciliter le procédé de fabrication d'une telle structure semiconductrice 1, un matériau du type « Spin On Glass », c'est-à-dire un matériau diélectrique adapté pour être déposé au moyen d'une centrifugeuse. En effet, le dépôt par centrifugation d'un tel matériau permet de combler aisément et efficacement les espaces restés vacant entre les nanofils 200.

Selon une possibilité non illustrée et non préférée, il est également possible de ne pas combler l'espace entre les nanofils 200.

La seconde extrémité 220 de chacun des nanofils 200 affleure de la couche de matériau de remplissage 400 et est en contact avec le deuxième matériau semiconducteur 20.

Dans ce mode de réalisation, le deuxième matériau semiconducteur 20 prend la forme d'une couche 500 en contact avec la seconde extrémité 220 de chacun des nanofils 200 de manière à former la jonction 50. Le deuxième matériau semiconducteur 20 est un matériau semiconducteur présentant une conductivité dont les porteurs majoritaires sont des trous, c'est-à-dire que le deuxième matériau semiconducteur 20 présente un dopage de type p.

Le deuxième matériau semiconducteur 20 est préférentiellement un semiconducteur grand gap, dont l'énergie de la bande interdite est voisine de celle du matériau semiconducteur 201 constituant les nanofils 200. Ainsi le deuxième matériau semiconducteur 20 peut être le nitrure de gallium (GaN), le séléniure de zinc (ZnSe) et le tellurure de zinc (ZnTe).

Le deuxième matériau semiconducteur 20 peut être, sans que l'on sorte du cadre de l'invention, le même matériau que le matériau semiconducteur 201 formant les nanofils 200 avec une conductivité de type p, ceci de manière à ce que la jonction 50 soit une homojonction, ou d'un autre matériau semiconducteur, ceci de manière à ce que la jonction 50 soit une hétérojonction.

Le deuxième matériau semiconducteur 20 forme une première partie 1b de la structure semiconductrice 1.

Le second contact électrique 40 est un contact électrique de type p de manière à limiter la résistance électrique avec le deuxième matériau semiconducteur 20.

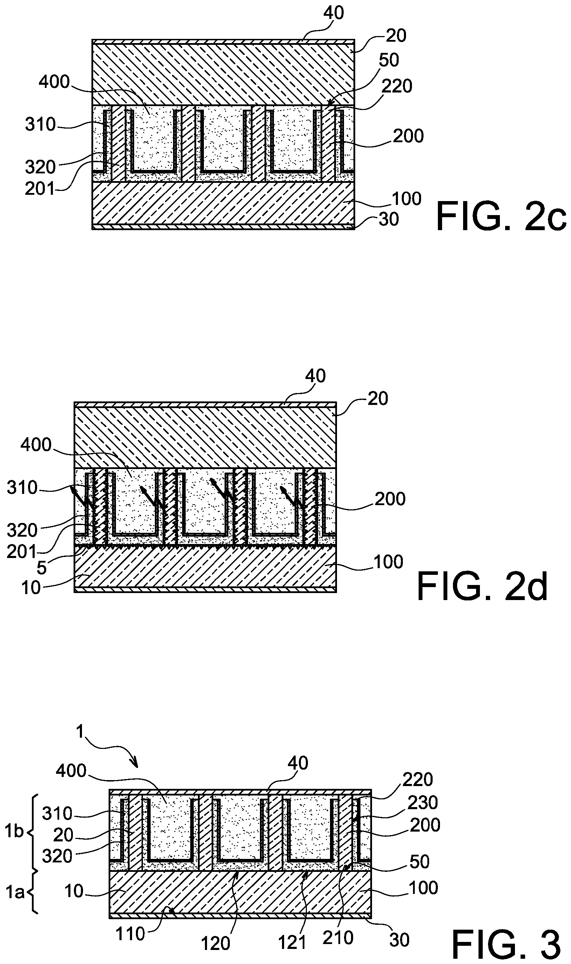

Le procédé de fabrication d'une telle structure semiconductrice 1 comporte, comme illustré sur les figures 2 a) à c), les étapes consistant à :
- fournir le substrat 100 réalisé dans le premier matériau semiconducteur 10,
- former, tel qu'illustré sur la figure 2a), une pluralité de nanofils 200 sur la seconde face 120, la première extrémité 210 étant, lors de cette formation, en contact avec la seconde face 120,
- déposer la couche de matériau isolant 310 sur les zones 121 de la seconde face 120 laissées libres par les nanofils 200 et sur les nanofils 200,
- déposer la couche conductrice 320 sur la couche de matériau isolant 310, tel qu'illustré sur la figure 2 b),
- supprimer, par une attaque sélective, telle qu'une attaque à ions réactif (d'acronyme anglais R.I.E.), la couche de matériau isolant 310 et la couche conductrice 320 de la seconde extrémité 220 de chacun des nanofils 200 et sur une partie du pourtour 230 de chacun des nanofils 200 à proximité de la seconde extrémité 220,
- déposer, par exemple par centrifugation si le matériau de remplissage est un matériau du type « spin on glass », le matériau de remplissage 400 de manière à ce que la seconde extrémité 220 de chacun des nanofils 200 affleure avec la surface du matériau de remplissage soit plane,
- déposer une couche du deuxième matériau semiconducteur 20 de manière à former la jonction 50,
- réaliser le premier contact électrique 30 en contact avec la première face 110,
- réaliser un second contact électrique 40 en contact avec le deuxième matériau semiconducteur 20 pour ainsi obtenir la structure semiconductrice illustrée sur la figure 2 c).

L'étape de formation des nanofils 200 étant connue par ailleurs, tel que dans les articles de I.C. Robin et de ses collaborateurs [4-5] cette étape n'est pas décrite dans ce document.

Dans ce procédé de fabrication, on entend par partie du pourtour 230 de chacun des nanofils 200 à proximité de la seconde extrémité 220, la partie du pourtour de chacun des nanofils 200 qui est à une distance prédéfinie de la seconde extrémité 220, cette distance prédéfinie étant comprise entre 5nm et 150nm, avec une valeur préférée sensiblement égale à 10nm.

Une fois formée, la structure semiconductrice 1 est apte à émettre de la lumière dont la longueur d'onde est définie par le matériau 201 des nanofils 200.

Cette émission, illustrée sur la figure 2d), est obtenue par une polarisation de la jonction 50 en direct, c'est-à-dire que le second contact électrique 40 est polarisé positivement relativement au premier contact électrique 30. Cette polarisation peut avoir une valeur comprise entre 1V et 30V, cette valeur devant être adaptée aux matériaux semiconducteurs 10, 20, 201 constituant la structure semiconductrice 1. Pour optimiser le rendement d'émission de la structure semiconductrice 1, la couche conductrice 320 est polarisée négativement relativement au premier contact électrique 30. Cette polarisation peut avoir une valeur -V comprise entre -1V et -30V, cette valeur devant être adaptée au matériau semiconducteur 201 constituant les nanofils.

De cette manière, et de façon identique à la structure semiconductrice 1 décrite dans le document FR 2934716, la polarisation de la couche électrique 320 permet, si elle est suffisante, de créer une inversion 5 du type de porteurs dans la deuxième partie la de la structure semiconductrice 1, c'est-à-dire au niveau des nanofils 200 et de la seconde face 120. Ainsi, l'inversion de porteurs dans la deuxième partie la, obtenue par injection de porteurs majoritaires de la première partie 2a dans la première partie au moyen de ladite polarisation, permet de déplacer la jonction dans la deuxième zone au niveau de ladite zone d'inversion en formant une « quasi-jonction ». Cette zone d'inversion s'étendant sur toute la longueur du nanofil 200 permet de créer une zone favorable à la recombinaison électron-trou dans laquelle la recombinaison des paires électron-trou donne lieu à de l'émission de lumière et donc la zone d'émission S'étend sur toute la hauteur des nanofils 200 et au niveau de la seconde face 120 comme le montre la figure 2d, ce qui permet d'obtenir une surface d'émission particulièrement importante.

Il peut également être noté que cette recombinaison a lieu à distance de la jonction 50 entre le matériau semiconducteur 201 formant les nanofils 200 et le deuxième matériau semiconducteur 20, et est donc à distance de cette même interface entre ces deux matériaux 201, 20 généralement riche en défauts recombinant non radiatif optimisant ainsi le rendement de la structure semiconductrice 1.

La figure 3 est une vue schématique en coupe transversale illustrant un deuxième mode de réalisation d'une structure semiconductrice 1 selon l'invention. Une structure semiconductrice 1 selon ce deuxième mode de réalisation se différencie de celle 1 selon le premier mode de réalisation en ce que chaque nanofil 200 est entièrement réalisé dans le deuxième matériau semiconducteur 20 de manière à former la première partie 1b de la structure semiconductrice 1 et en ce que la structure semiconductrice 1 ne comporte pas de couche 500 de deuxième matériau semiconducteur 20, le second contact électrique 40 étant réalisé en contact avec la seconde extrémité 220 de chacun des nanofils 200.

Dans une telle structure semiconductrice 1, la jonction 50 est présente à l'interface entre la première extrémité 210 de chacun des nanofils 200 et la seconde face 120, la seconde face 120 formant la deuxième partie la de la structure semiconductrice 1.

Dans ce mode de réalisation, le premier matériau semiconducteur 10 est choisi en fonction de la longueur d'onde d'émission souhaitée de la structure semiconductrice 1. Ainsi pour une émission de lumière dans la gamme des proches UV, le premier matériau semiconducteur 10 peut être de l'oxyde de zinc (ZnO) ou du nitrure de gallium (GaN) . Pour une émission dans la gamme des UV profond, le premier matériau semiconducteur 10 peut être l'oxyde de zinc manganèse (ZnMgO) ou nitrure de gallium-aluminium (AlGaN).

Selon ce même mode de réalisation, le deuxième matériau semiconducteur 20 est préférentiellement un semiconducteur grand gap, dont l'énergie de la bande interdite est voisine de celle du premier matériau semiconducteur 10.

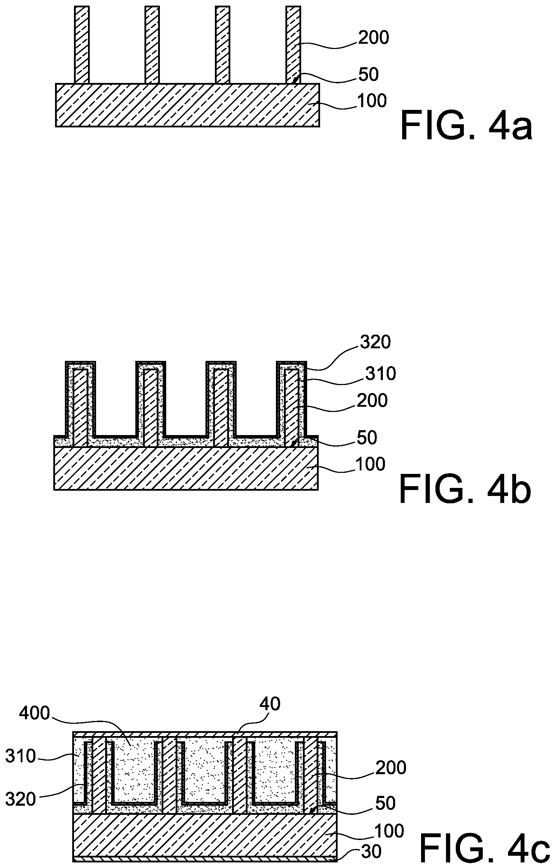

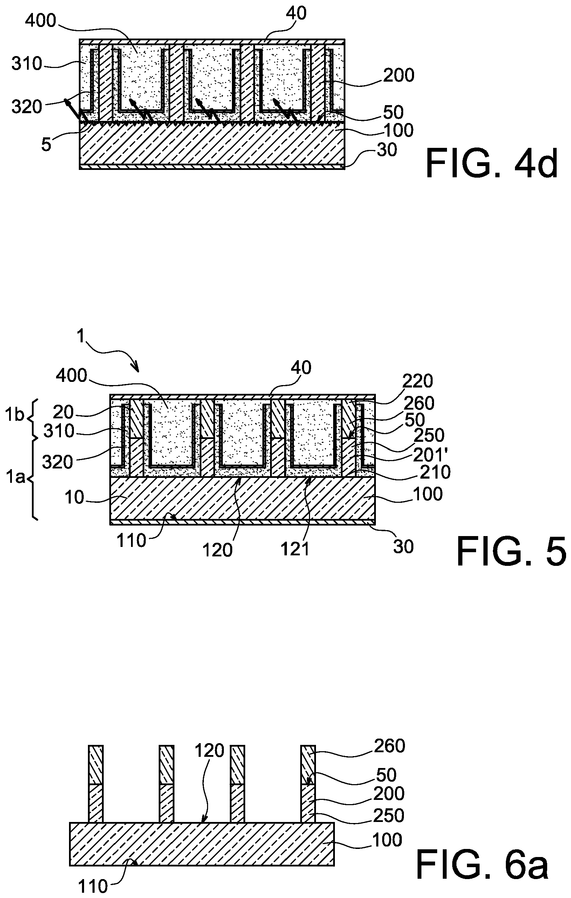

Le procédé de fabrication d'une structure semiconductrice 1 selon ce mode de réalisation, tel qu'illustré sur les figures 4 a) à c), se différencie d'un procédé de fabrication d'une structure semiconductrice 1 selon le premier mode de réalisation en ce qu'il ne comprend pas d'étape consistant à déposer une couche 500 du deuxième matériau semiconducteur 20 et en ce que l'étape consistant à réaliser un second contact électrique 40 est réalisé en contact avec la seconde extrémité 220 de chacun des nanofils 200.

L'émission de lumière avec une structure semiconductrice 1 selon le deuxième mode de réalisation est obtenue, tel qu'illustré sur la figure 4 d), de façon similaire à celle d'une structure semiconductrice 1 selon le premier mode de réalisation.

La figure 5 illustre un troisième mode de réalisation d'une structure semiconductrice 1 selon l'invention, une telle structure semiconductrice 1 se différencie d'une structure semiconductrice 1 selon le deuxième mode de réalisation en ce que chacun des nanofils 200 comporte une première portion 250 dans un matériau semiconducteur 201' de même type de conductivité que le premier matériau semiconducteur 10 et une deuxième portion 260 dans le deuxième matériau semiconducteur 20, l'interface entre ces deux portions 250, 260 formant la jonction 50 de la structure semiconductrice 1. Selon ce mode de réalisation la deuxième portion 260 forme la première partie 1b de la structure semiconductrice 1, la première portion 250 et la seconde face 120 formant la deuxième partie la.

Le matériau semiconducteur 201' de la première portion 250 est un semiconducteur grand gap à gap direct. Le matériau semiconducteur 201' de la première portion peut être avantageusement un matériau sensiblement identique au premier matériau semiconducteur 10.

Le matériau semiconducteur 201' de la première portion 250 est adapté à la longueur d'onde d'émission souhaitée de la structure semiconductrice 1. Ainsi pour une émission de lumière dans la gamme des proches UV, le matériau semiconducteur 201' de la première portion 250 peut être de l'oxyde de zinc (ZnO) ou du nitrure de gallium (GaN) . Pour une émission dans la gamme des UV profond, le matériau semiconducteur 201' de la première portion 250 peut être l'oxyde de zinc manganèse (ZnMgO) ou du nitrure de gallium-aluminium (AlGaN).

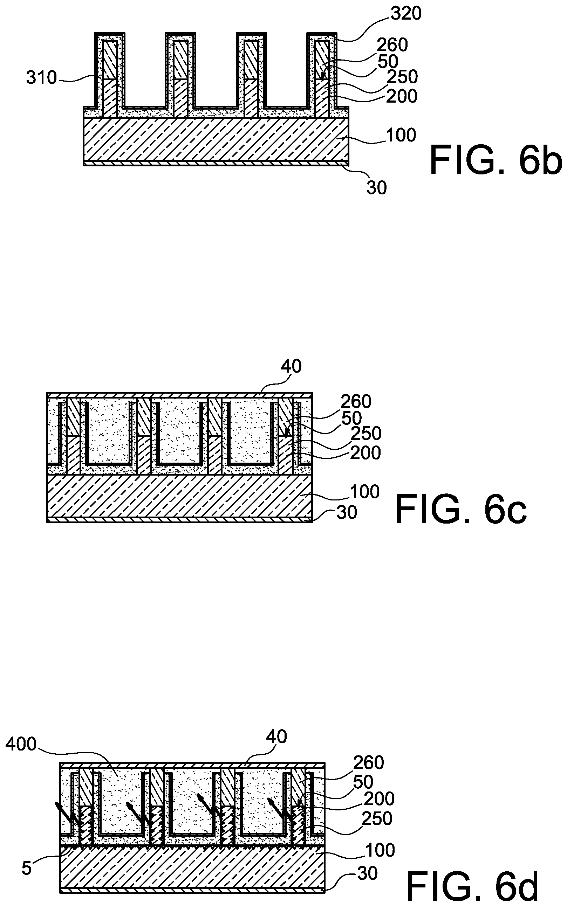

Le procédé de fabrication d'une structure semiconductrice 1 selon ce troisième mode de réalisation, tel qu'illustré sur les figures 6 a) à c), se différencie d'un procédé de fabrication d'une structure semiconductrice 1 selon le deuxième mode de réalisation par l'étape de formation de la pluralité de nanofils 200.

En effet, cette étape, pour permettre la réalisation d'une telle structure semiconductrice 1 comprend notamment un changement du matériau déposé pendant la croissance des nanofils 200, ceci de manière à ce que chacun des nanofils 200 puisse présenter la première portion 250 réalisée dans le matériau semiconducteur 201' de la première portion et la deuxième portion 260 réalisée dans le deuxième matériau semiconducteur 20.

L'émission de lumière avec une structure semiconductrice 1 selon le troisième mode de réalisation est obtenue, tel qu'illustré sur la figure 6 d), de façon similaire à celle d'une structure semiconductrice 1 selon le premier mode de réalisation.

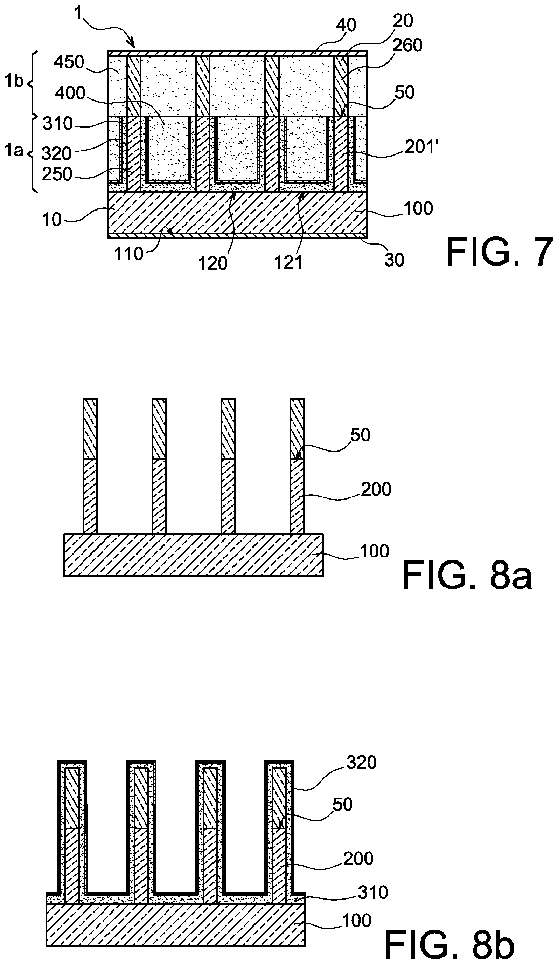

La figure 7 est une vue schématique en coupe transversale illustrant une structure semiconductrice 1 selon un quatrième mode de réalisation. Une telle structure semiconductrice 1 se différencie d'une structure semiconductrice 1 selon le troisième mode de réalisation en ce que la première portion 250 et la seconde portion 260 de chaque nanofils 200 sont toutes deux réalisées dans un même matériau 201', 20 avec un dopage de type n pour la première portion 250 et un dopage de type p pour la deuxième portion 260 de manière à former la jonction 50, en ce que les couches de matériau isolant 310 et de métal 320 sont présents uniquement sur la première portion 250 de chacun des nanofils 200, le matériau de remplissage 400 étant présent autour de ces mêmes portions 250 de nanofils 200 et en ce que la structure semiconductrice 1 présente un polymère dopant 450 remplissant l'espace entre les nanofils 200 au niveau de leur deuxième portion 260.

Dans ce mode de réalisation le deuxième matériau semiconducteur 20 et le matériau semiconducteur 201' de la première portion 250 de chacun des nanofils 200 sont tous deux un matériau grand gap à gap direct de type n dont le dopage, pour le deuxième matériau semiconducteur 20, a été inversé en un dopage type p par une activation du polymère dopant 450.

Le deuxième matériau semiconducteur 20 et le matériau semiconducteur 201'de la première portion 250 de chacun des nanofils 200 est préférentiellement de l'oxyde de zinc (ZnO), mais ils peuvent être également tout matériau semiconducteur grand gap à gap direct pouvant présenter un dopage n et dont le dopage peut être inversé par la mise en contact avec un polymère dopant 450 et l'activation de ce dernier.

Le polymère dopant 450 est un polymère comprenant des ions dopant aptes à migrer dans le matériau semiconducteur en contact avec ledit polymère lors d'une étape d'activation, telle qu'une activation thermique. Ce type de polymère dopant 450 forme un matériau dopant.

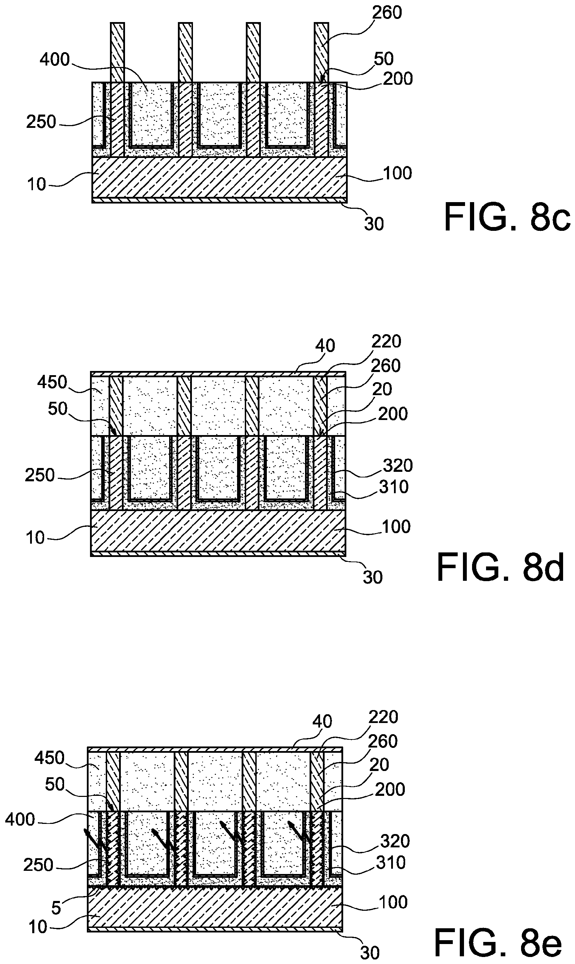

Le procédé de fabrication d'une structure semiconductrice 1 selon ce mode de réalisation, tel qu'illustré sur les figures 8 a) à d), se différencie d'un procédé de fabrication d'une structure semiconductrice 1 selon le troisième mode de réalisation en ce qu'après l'étape de formation des nanofils 200, le procédé de fabrication comprend les étapes consistant à :
- déposer une couche de remplissage 400 de manière à ce que l'espace entre les nanofils 200 soit rempli et de manière à ce qu'une première portion 250 de chacune des nanofils 200 soit recouverte et à ce qu'une seconde portion 260 de chacun des nanofils 200 dépasse de ladite couche de remplissage 400,
- supprimer, tel qu'illustré figure 8 c) la couche conductrice 320 et la couche isolante 310 de la deuxième portion 260 de chacune des nanofils 200,
- déposer une couche de polymère dopant 450, ladite couche de polymère dopant 450 étant déposée de manière à ce que la seconde extrémité 220 de chacun des nanofils 200 affleure,
- effectuer une activation de la couche de matériau dopant 450 de manière à permettre le dopage de la deuxième portion 260 de chacun des nanofils 200 et ainsi former le deuxième matériau semiconducteur 20,
- réaliser le premier contact électrique 30 en contact avec la première face 110,
- réaliser le second contact électrique 40 en contact avec la seconde extrémité 220 de chacun des nanofils 200 pour ainsi obtenir la structure semiconductrice illustrée sur la figure 8 d).

L'émission de lumière avec une structure semiconductrice 1 selon ce mode de réalisation est obtenue, tel qu'illustré sur la figure 8 e) de façon similaire à celle d'une structure semiconductrice 1 selon le premier mode de réalisation.

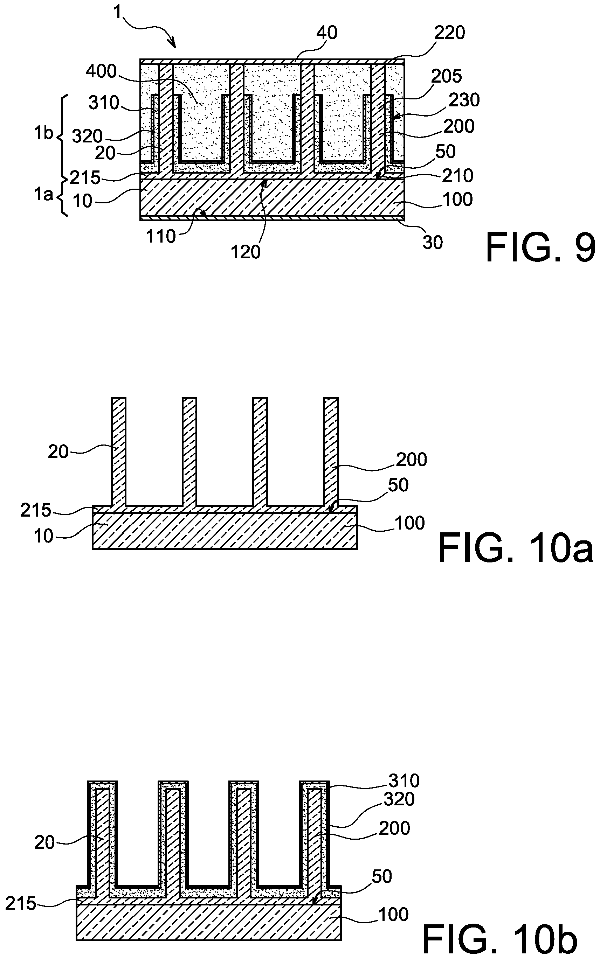

La figure 9 est une vue schématique en coupe transversale illustrant une structure semiconductrice 1 selon un cinquième mode de réalisation. Une telle structure semiconductrice 1 se différencie d'une structure semiconductrice 1 selon le deuxième mode de réalisation en ce que chaque nanofil 200 comprend à sa première extrémité 210 une portion de couche de mouillage 215, l'interface entre ladite portion de couche de mouillage 215 et la seconde face 120 formant la jonction 50, en ce que la couche d'isolant 310 est en contact avec les nanofils 200 sans aucun contact avec la seconde face 120 et en ce que le type de conductivité du premier et du deuxième matériau semiconducteur 10, 20 est inversé, le premier matériau semiconducteur 10 présentant un dopage de type p et le deuxième matériau semiconducteur 20 présentant un dopage de type n.

Dans ce mode de réalisation on entend donc par nanofil 200, le corps du nanofil 205 en lui-même, c'est-à-dire la partie allongée du nanofil 200, et une portion de la couche de matériau résiduel 215 issus de la croissance des nanofils 200 et présente sur la seconde face 120, cette couche étant généralement nommée couche de mouillage. En effet, selon le type de croissance de nanofils 200 utilisé, comme décrit dans l'article de I.C. ROBIN et ses colaborater[5], il peut exister, consécutivement à la croissance du nanofil 200, une couche dite de mouillage. Une telle couche, du même type que le matériau formant le corps 205 de chacun des nanofils 200, ne présente aucune discontinuité avec le corps 205 de chacun des nanofils 200.

Dans ce mode de réalisation, le type de conductivité du premier et du deuxième matériau semiconducteur 10, 20 étant inversé, les types de contact électrique du premier et du deuxième contact électrique 30, 40 sont préférentiellement inversés. Ainsi le premier contact électrique 30 est un contact électrique de type p et le deuxième contact électrique est préférentiellement un contact électrique de type n.

La couche de mouillage selon ce mode de réalisation est d'une épaisseur comprise entre 10nm et 150nm avec une épaisseur préférée sensiblement égale à 100nm.

Dans ce cinquième mode de réalisation, les nanofils 200 forment la première partie 1b de la structure semiconductrice 1 et la seconde face 120 forme la deuxième partie la de la structure semiconductrice 1.

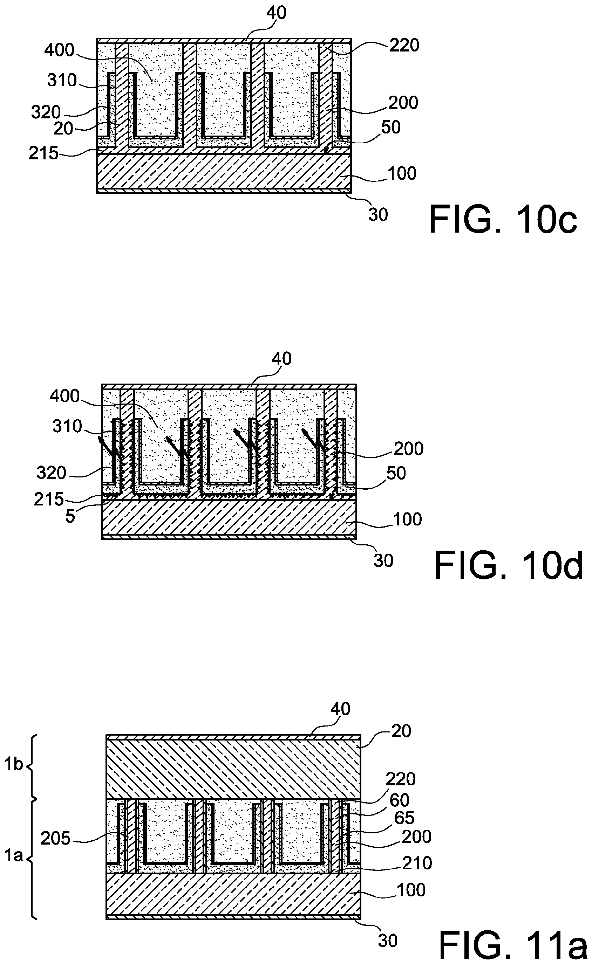

Le procédé de fabrication d'une structure semiconductrice 1 selon ce mode de réalisation, tel qu'illustré par les figures 10 a) à d), se différencie d'un procédé de fabrication d'une structure semiconductrice 1 selon le deuxième mode de réalisation par l'étape de formation des nanofils 200, l'étape de formation des nanofils 200 selon ce mode de réalisation étant une étape de formation comprenant la formation d'une couche de mouillage concomitamment ou précédemment à la formation des corps 205 des nanofils 200.

L'émission de lumière avec une structure semiconductrice 1 selon ce cinquième mode de réalisation se différencie dans l'inversion de la tension de polarisation de la jonction 50. En effet, la jonction 50 étant inversée, une polarisation en direct nécessite que le second contact électrique 40 soit polarisé négativement relativement au premier contact 30 électrique.

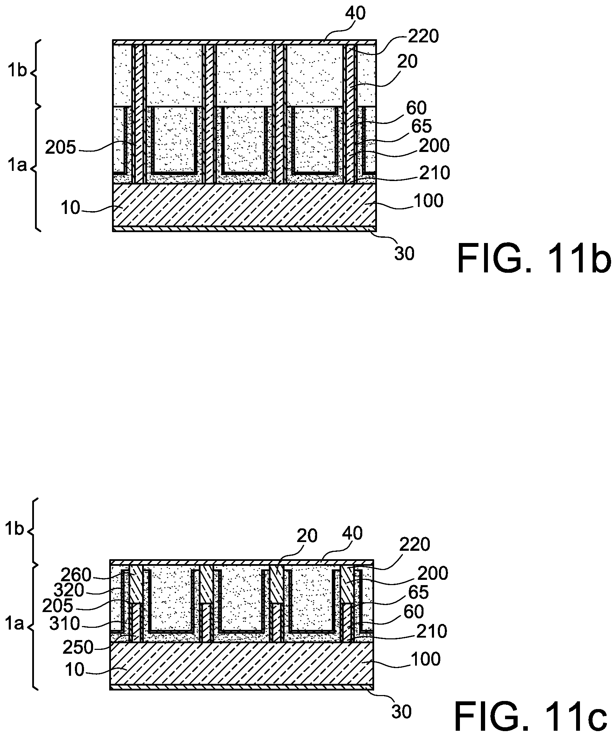

Les figures 11 a) à c) illustrent des possibilités de l'invention pour respectivement le premier, le quatrième et le troisième mode de réalisation. Les structures semiconductrices 1 selon ces possibilités se différencient des structures semiconductrices 1 selon les modes de réalisation dont elles découlent en ce qu'au moins une portion de chacun des nanofils 200 présente une conformation « coeur-coquille ».

On entend par conformation « coeur-coquille », une conformation d'au moins une portion de nanofil 200 constituée d'au moins deux matériaux 50, 65, un matériau 60, dit coeur, formant le centre de la portion de nanofil 200 et un matériau 65, dit coquille, formant le contour extérieur de la portion de nanofil 200. Une telle conformation peut également présenter trois ou quatre matériaux selon un principe similaire, les matériaux étant agencés sensiblement concentriquement par rapport à l'axe de la portion de nanofil 200.

Ainsi, selon une configuration simple d'un seul matériau coeur 60 et un seul matériau coquille 65 et dans un but de simple illustration de cette possibilité, le matériau coeur 60 peut être de l'oxyde de zinc (ZnO) ou du nitrure de gallium (GaN), le matériau coquille 65 pouvant être respectivement pour ces deux matériaux l'oxyde de zinc manganèse (ZnMgO) et du nitrure de gallium-aluminium (AlGaN).

Un tel agencement permet un meilleur confinement et une limitation des défauts recombinants non radiatifs présents au niveau du contour de chaque nanofil 200.

Les figures 11 a) et b) illustrent plus particulièrement une structure semiconductrice 1 selon respectivement le premier et le quatrième mode de réalisation avec des nanofils 200 présentant une conformation « coeur-coquille » sur l'ensemble de leur corps 205.

La figure 11 c) illustre quant à elle une structure semiconductrice 1 selon le troisième mode de réalisation avec seulement la première portion 250 de chacun des nanofils 200 présentant une conformation du type « coeur-coquille ».

Les procédés de fabrication de structures semiconductrices 1 selon cette possibilité se différencient des procédés de fabrication de structures semiconductrices 1 selon le mode de réalisation dont elles sont issues, en ce que l'étape de formation des nanofils 200 comprend au moins une étape de croissance du matériau coeur 60 et une étape de croissance latérale du matériau coquille 65 autour du matériau coeur 60.

L'émission de lumière avec des structures semiconductrices 1 selon cette possibilité est obtenue de façon identique à celle des structures semiconductrices 1 selon les modes de réalisation dont elles sont issues

Ces trois exemples de structures semiconductrices 1 selon l'invention pouvant comprendre des nanofils 200 comportant au moins une portion présentant une conformation « coeur-coquille » ne sont présentés qu'à titre illustratif et ne sont donc pas limitatif. En effet, l'ensemble des structures selon les modes de réalisation décrits dans ce document peuvent comprendre des nanofils 200 comportant au moins une portion présentant une conformation « coeur-coquille », cette portion étant préférentiellement une portion de chaque nanofil 200 destinée à émettre de la lumière.

Selon une autre possibilité de l'invention, non illustrée, chacun des nanofils 200 peut comporter une conformation de type « puits quantique » sur au moins une des ces portions, ladite portion étant préférentiellement choisie comme étant une portion émettrice de lumière. Ainsi, on entend par conformation « puits quantique », le fait que lesdites portions de nanofil 200 comprennent une succession de matériau présentant des bandes interdites de différentes énergies de manière à créer des zones de confinement quantique favorisant, de la même façon que pour une conformation « coeur-coquille », les recombinaisons radiatives. Les matériaux formant une telle conformation peuvent être, par exemple, du même type que ceux utilisés pour une conformation « coeur-coquille », c'est-à-dire de l'oxyde de Zinc (ZnO) ou du nitrure de gallium (GaN) pour le matériau « puits », i.e. dans lequel à lieu le confinement quantique, et de l'oxyde de zinc manganèse (ZnMgO) ou de nitrure de gallium-alluminium (GaAlN) pour le matériau « barrière », i.e. le matériau créant la barrière de potentiel de manière à confiner les porteurs dans le matériau « puits ». Ces exemples sont donnés qu'à titre illustratif et ne sont nullement limitatifs.

Dans la majorité des modes de réalisation décrits ci-dessus, le substrat 100 a été choisi volontairement comme présentant une conductivité de type n, il est également envisageable d'inverser le type de conductivité de l'ensemble des matériaux composant 10, 20, 201, 201', 60, 65, les structures semiconductrices 1 décrites, le substrat 100 présentant alors une conductivité de type p et les tensions de polarisation devant être inversées, sans que l'on sorte du cadre de l'invention.

De même, l'ordre des étapes des procédés de fabrication décrits ci-dessus est pour une partie de ces étapes purement arbitraire, ainsi il est par exemple envisageable, sans modification des structures semiconductrices 1 obtenues par de tels procédés de fabrication et sans que l'on sorte du cadre de l'invention, d'effectuer l'étape de réalisation du premier contact 30 avant l'étape de formation des nanofils 200.

De même, si dans l'ensemble des modes de réalisation, les micro- ou nano- structures sont formées par des nanofils 200, il est également possible de former de telles micro- ou nano- structures par des piliers semi-conducteurs présentant une forme autre que celle de nanofils ou par un ensemble de lamelles semiconductrices parrallèles entre elles dont un des côtés longitudinaux est en contact avec la seconde face 120, ou par tout autre type de micro- ou nano-structures présentant au moins une dimension réduite selon l'une des directions sensiblement parallèles à la seconde face 120 de manière à former une micro- ou nano- structure 2D ou préférentiellement 1D.

### Références

[1] S. J. Jiao et Al. Applied Physics Letters 88 (2006) pages 031911 à 031913.
[2] H. Ohta et Al, Applied Physics Letters 83, (2003) pages 1029 à 1031.
[3] J. Simon et Al, Science 327 (2010) pages 60 à 64.
[4] I.C. Robin et Al, Micoelectronics Journal, 40 (2009) pages 250 à 252.
[5] I.C. Robin et Al, Appl. Phys. Lett., 91, (2007) pages 143120 à 143122.

## Revendications

1. Structure semiconductrice (1) adaptée pour émettre de la lumière comportant :
- un substrat (100) réalisé en un premier matériau semiconducteur (10) présentant un premier type de conductivité, le substrat (100) présentant une première et une seconde face (110, 120),
- un premier contact électrique (30) sur la première face (110),
- au moins un deuxième matériau semiconducteur (20), présentant un second type de conductivité formant une première partie (1b) de la structure semiconductrice (1) et en contact électrique avec une deuxième partie (la) de la structure semiconductrice (1) présentant la première conductivité de manière à former une jonction (50),
- un second contact électrique (40) connecté électriquement avec le deuxième matériau semiconducteur (20),
- un moyen de polarisation adapté pour polariser au moins une partie (la, 1b) de la structure semiconductrice parmi la première et la deuxième partie (la, 1b), le moyen de polarisation étant agencé de manière à ce que sa polarisation entraîne une inversion du type de porteurs dans ladite partie (la, 1b) par injection dans ladite partie (la, 1b) de porteurs majoritaires de l'autre partie (1b, la), ceci de manière à déplacer la jonction dans ladite partie (la, 1b),
la structure semiconductrice (1) comportant en outre :
- une pluralité de micro- ou nano-structures (200) présentant chacune une première et une seconde extrémité (210, 220), chacune des premières extrémités (210) étant reliée à la seconde face (120), chaque micro- ou nano- structure (200) comportant au moins une portion réalisée dans le deuxième matériau semiconducteur (20) de manière à former la première partie (1b), ou chaque micro- ou nano- structure (200) présentant le premier type de conductivité avec la seconde extrémité (220) en contact avec le deuxième matériau semiconducteur (20), ceci de manière à former la jonction (50),
la structure semiconductrice (1) **étant caractérisée en ce qu'** une part de ladite micro- ou nano- structure (200) et la seconde face (110) forment la partie parmi la première et la deuxième partie (1a,1b) pour laquelle le moyen d'injection présente un agencement pour entraîner par sa polarisation une inversion du type de porteurs dans ladite partie (la, 1b) par injection dans ladite partie (la, 1b) de porteurs majoritaires de l'autre partie (1b, la)..

2. Structure semiconductrice (1) selon la revendication 1, dans laquelle le moyen de polarisation comporte une couche d'isolant (310) en contact avec la partie (la, 1b) de la structure semiconductrice (1) à polariser et une couche conductrice (320) sur ladite couche d'isolant (310).

3. Structure semiconductrice (1) selon la revendication 2, dans laquelle la couche d'isolant (310) est en contact avec les zones (121) de la seconde face (120) laissées libres par les micro- ou nano-structures (200) et sur au moins une partie de chaque micro- ou nano- structure (200).

4. Structure semiconductrice (1) selon l'une quelconque des revendications précédentes, dans laquelle chaque micro ou nano- structure (200) est un nanofil semiconducteur.

5. Structure semiconductrice (1) selon l'une quelconque des revendications précédentes, dans laquelle chaque micro- ou nano- structure (200) présente une conductivité du même type que celle du premier matériau semiconducteur (10) de manière à former la deuxième partie (la), la seconde extrémité (220) de chacune des micro- ou nano- structures (200) étant en contact avec le deuxième matériau semiconducteur (20).

6. Structure semiconductrice (1) selon l'une quelconque des revendications 1 à 4, dans laquelle chaque micro ou nano- structure (200) présente :
- une première portion (250) comportant la première extrémité (210), et présentant une conductivité du même type que celle du premier matériau semiconducteur (10) de manière à former la deuxième partie (la), et
- une seconde portion (260) comportant la seconde extrémité (220), et étant réalisée dans le deuxième matériau semiconducteur (20) de manière à former la première partie (1b).

7. Structure semiconductrice (1) selon la revendication 4, dans laquelle au moins une portion (200, 250, 260) de chaque nanofil (200) comporte une conformation du type « coeur-coquille », c'est-à-dire que la portion du nanofil est constituée d'au moins deux matériaux semiconducteurs (60, 65), l'un (60), dit matériau coeur, formant le centre de ladite portion (200, 250, 260) du nanofil (200) et l'autre (65), dit matériau coquille, entourant le matériau coeur (60) de manière à former le contour extérieur de la portion (200, 250, 260) de nanofil (200).

8. Structure semiconductrice (1) selon la revendication 6 en combinaison avec la revendication 7, dans laquelle chaque nanofil (200) présente une seule portion (250, 260) de nanofil comportant une conformation « coeur-coquille », ladite portion (250, 260) de nanofil étant une portion (250, 260) sélectionnée dans le groupe comportant la première portion (250) et la seconde portion (260).

9. Structure semiconductrice (1) selon l'une quelconque des revendications précédentes, dans laquelle la partie (la, 1b) de la première et de la seconde partie (la, 1b) présentant une conductivité dont les porteurs majoritaires sont des électrons est réalisée dans un matériau semiconducteur présentant un dopage de type n, ledit matériau semiconducteur étant préférentiellement sélectionné dans le groupe comportant l'oxyde de zinc (ZnO), l'oxyde de zinc manganèse (ZnMgO), le nitrure de gallium (GaN), le nitrure de gallium-aluminium (AlGaN).

10. Structure semiconductrice (1) selon l'une quelconque des revendications précédentes, dans laquelle la partie (1a, 1b) de la première et de la seconde partie (1a, 1b) présentant une conductivité dont les porteurs majoritaires sont des trous est réalisée dans un matériau semiconducteur présentant un dopage de type p, ledit matériau semiconducteur étant préférentiellement sélectionné dans le groupe comportant le nitrure de gallium (GaN), le séléniure de zinc (ZnSe) et le tellurure de zinc (ZnTe).

11. Procédé de fabrication d'une structure semiconductrice (1) selon l'une quelconque des revendications 1 à 10, ledit procédé de fabrication comportant les étapes consistant à :
- fournir un substrat (100) réalisé dans un premier matériau semiconducteur (10) présentant un premier type de conductivité, ledit substrat (100) présentant une première et une seconde face (110, 120),
- réaliser un premier contact électrique (30) sur la première face (110),
- former une pluralité de micro- ou nano-structures (200) sur la seconde face (120), chacune des micro- ou nano- structures (200) présentant une première et une seconde extrémité (210, 220) avec chacune des premières extrémités (210) connectée à la seconde face (120), chaque micro- ou nano- structures (200) comportant au moins une portion réalisée dans un deuxième matériau semiconducteur (20) présentant, ou à même de présenter par l'action d'un matériau dopant (450), une conductivité d'un deuxième type de manière à former une première partie (1b) de la structure semiconductrice (1) avec le substrat (100) et/ou une autre portion de chacune des micro- ou nano- structures (200) formant une deuxième partie (la) de la structure semiconductrice (1), ou chaque micro- ou nanostructure (200) présentant le premier type de conductivité et formant au moins partiellement une deuxième partie (la) de la structure semiconductrice (1),
- former un moyen de polarisation adapté pour polariser au moins une partie (la, 1b) parmi la première et la deuxième partie (la, 1b), le moyen de polarisation étant agencé de manière à ce que sa polarisation entraîne une inversion du type de porteurs dans ladite partie (la, 1b),
- déposer, si chaque micro- ou nanostructure (200) présente le premier type de conductivité et forme au moins partiellement la deuxième partie (la), un deuxième matériau semiconducteur (20) de manière à former la première partie (1b),
- réaliser un second contact électrique (40) en contact avec le deuxième matériau semiconducteur (20),
dans lequel une part de ladite micro- ou nano- structure (200) et la seconde face (110) forment la partie parmi la première et la deuxième partie (1a, 1b) pour laquelle le moyen d'injection présente un agencement pour entraîner par sa polarisation une inversion du type de porteurs dans ladite partie (1a, 1b) par injection dans ladite partie (1a, 1b) de porteurs majoritaires de l'autre partie (1b, 1a)..

12. Procédé de fabrication selon la revendication 11 dans lequel le procédé de fabrication est un procédé de fabrication d'une structure semiconductrice (1) selon la revendication 2 ou l'une des revendication 3 à 12 en combinaison avec la revendication 2, l'étape consistant à former un moyen de polarisation comportant les étapes consistant à:
- déposer une couche d'isolant (310) sur les zones (121) de la seconde face (120) laissées libres par les micro- ou nano- structures (200) et sur au moins une portion de chaque micro- ou nano-structures (200),
- déposer sur la couche conductrice (320) sur la couche d'isolant (310).

13. Procédé de fabrication selon la revendication 11 ou 12 dans lequel, le procédé de fabrication comprend après l'étape consistant à former un moyen de polarisation et avant l'étape consistant à réaliser le second contact électrique, les étapes consistant à en outre :
- Supprimer la part de la couche d'isolant (310) et de la couche conductrice (320) présent sur chacune des micro- ou nano- structures au niveau de leur seconde extrémité (220) et au moins au niveau du pourtour (230) à proximité de la seconde extrémité (220) sur chacune des micro- ou nano- structures (200),
- déposer un matériau de remplissage (400) de manière à ce que l'espace entre les micro- ou nano-structures (200) soit au moins partiellement rempli et que chacune des micro- ou nano- structures (200) présente au moins une portion recouverte.

## Patentansprüche

1. Halbleiterstruktur (1), welche dafür ausgelegt ist, Licht auszustrahlen, umfassend:
- ein aus einem ersten Halbleitermaterial (10) ausgeführtes Substrat (100) mit einem ersten Leitfähigkeitstyp, wobei das Substrat (100) eine erste und eine zweite Seite (110, 120) aufweist,
- einen ersten elektrischen Kontakt (30) auf der ersten Seite (110),
- wenigstens ein zweites Halbleitermaterial (20) mit einem zweiten Leitfähigkeitstyp, welches einen ersten Teil (1b) der Halbleiterstruktur (1) bildet und in elektrischem Kontakt mit einem zweiten Teil (1a) der Halbleiterstruktur (1) steht, die die erste Leitfähigkeit aufweist, so dass eine Verbindung (50) gebildet wird,
- einen zweiten elektrischen Kontakt (40), der mit dem zweiten Halbleitermaterial (20) elektrisch verbunden ist,
- ein Polarisationsmittel, das dafür ausgelegt ist, wenigstens einen Teil (1a, 1b) der Halbleiterstruktur aus erstem und zweitem Teil (1a, 1b) zu polarisieren, wobei das Polarisationsmittel so angeordnet ist, dass seine Polarisation durch Injektion von Majoritätsträgern des anderen Teils (1b, 1a) in den Teil (1a, 1b) eine Inversion vom Trägertyp in dem Teil (1a, 1b) bewirkt, sodass die Verbindung in dem Teil (1a, 1b) verschoben wird,
wobei die Halbleiterstruktur (1) ferner umfasst:
- eine Vielzahl von Mikro- oder Nanostrukturen (200), die jede ein erstes und ein zweites Ende (210, 220) aufweisen, wobei jedes der ersten Enden (210) mit der zweiten Seite (120) verbunden ist, wobei jede Mikro- oder Nanostruktur (200) wenigstens einen Abschnitt aufweist, der aus dem zweiten Halbleitermaterial (20) ausgeführt ist, so dass der erste Teil (1b) gebildet wird, oder wobei jede Mikro- oder Nanostruktur (200) den ersten Leitfähigkeitstyp mit dem zweiten Ende (220) in Kontakt mit dem zweiten Halbleitermaterial (20) aufweist, um die Verbindung (50) zu bilden,
wobei die Halbleiterstruktur (1) **dadurch gekennzeichnet ist, dass** ein Teil der Mikro-oder Nanostruktur (200) und die zweite Seite (110) den Teil aus erstem und zweitem Teil (1a, 1b) bilden, für den das Injektionsmittel eine Anordnung aufweist, um durch seine Polarisation durch Injektion von Majoritätsträgern des anderen Teils (1b, 1a) in den Teil (1a, 1b) eine Inversion vom Trägertyp in dem Teil (1a, 1b) zu bewirken.

2. Halbleiterstruktur (1) nach Anspruch 1, bei welcher das Polarisationsmittel eine Isolierschicht (310) in Kontakt mit dem Teil (1a, 1b) der zu polarisierenden Halbleiterstruktur (1), aufweist und eine leitende Schicht (320) auf der Isolierschicht (310).

3. Halbleiterstruktur (1) nach Anspruch 2, bei welcher die Isolierschicht (310) in Kontakt mit den Bereichen (121) der zweiten Seite (120) ist, die von den Mikro- oder Nanostrukturen (200) freigelassen sind und auf wenigstens einem Teil jeder Mikro- oder Nanostruktur (200).

4. Halbleiterstruktur (1) nach einem der vorhergehenden Ansprüche, bei welcher jede Mikro- oder Nanostruktur (200) eine Halbleiter-Nanofaser ist.

5. Halbleiterstruktur (1) nach einem der vorhergehenden Ansprüche, bei welcher jede Mikro- oder Nanostruktur (200) eine Leitfähigkeit desselben Typs aufweist wie die des ersten Halbleitermaterials (10), um den zweiten Teil (1a) zu bilden, wobei das zweite Ende (220) jeder der Mikro- oder Nanostrukturen (200) in Kontakt mit dem zweiten Halbleitermaterial (20) ist.

6. Halbleiterstruktur (1) nach einem der Ansprüche 1 bis 4, bei welcher jede Mikro- oder Nanostruktur (200) aufweist:
- einen ersten Abschnitt (250), der das erste Ende (210) umfasst und eine Leitfähigkeit desselben Typs aufweist wie die des ersten Halbleitermaterials (10), um den zweiten Teil (1a) zu bilden, und
- einen zweiten Abschnitt (260), der das zweite Ende (220) umfasst und aus dem zweiten Halbleitermaterial (20) ausgeführt ist, um den ersten Teil (1b) zu bilden.

7. Halbleiterstruktur (1) nach Anspruch 4, bei welcher wenigstens ein Abschnitt (200, 250, 260) jeder Nanofaser (200) eine Ausbildung vom Typ ,Kern-Schale' umfasst, das heißt, dass der Abschnitt der Nanofaser aus wenigstens zwei Halbleitermaterialien (60, 65) gebildet ist, wobei das eine (60), das sogenannte Kernmaterial, die Mitte des Abschnitts (200, 250, 260) der Nanofaser (22) bildet und das andere (65), das sogenannte Schalenmaterial, das Kernmaterial (60) umgibt, um den Außenumfang des Abschnitts (200, 250, 260) der Nanofaser (200) zu bilden.

8. Halbleiterstruktur (1) nach Anspruch 6 in Kombination mit Abschnitt 7, bei welcher jede Nanofaser (200) einen einzelnen Nanofaser-Abschnitt (250, 260) aufweist, der eine 'Kern-Schale'-Ausbildung umfasst, wobei der Nanofaser-Abschnitt (250, 260) ein Abschnitt (250, 260) ist, der aus der Gruppe gewählt ist, die den ersten Abschnitt (250) und den zweiten Abschnitt (260) umfasst.

9. Halbleiterstruktur (1) nach einem der vorhergehenden Ansprüche, bei welcher der Teil (1a, 1b) aus erstem und zweiten Teil (1a, 1b), der eine Leitfähigkeit aufweist, deren Majoritätsträger Elektronen sind, aus einem Halbleitermaterial ausgeführt ist, das eine Dotierung vom Typ n aufweist, wobei das Halbleitermaterial vorzugsweise aus der Gruppe gewählt ist, die umfasst: Zinkoxid (ZnO), Zink-Manganoxid (ZnMgO), Galliumnitrid (GaN), Gallium-Aluminiumnitrid (AlGaN).

10. Halbleiterstruktur (1) nach einem der vorhergehenden Ansprüche, bei welcher der Teil (1a, 1b) aus erstem und zweiten Teil (1a, 1b), der eine Leitfähigkeit aufweist, deren Majoritätsträger Löcher sind, aus einem Halbleitermaterial ausgeführt ist, das eine Dotierung vom Typ p aufweist, wobei das Halbleitermaterial vorzugsweise aus der Gruppe gewählt ist, die umfasst: Galliumnitrid (GaN), Zinkselenid (ZnSe) und Zinktellurid (ZnTe).

11. Herstellungsverfahren für eine Halbleiterstruktur (1) nach einem der Ansprüche 1 bis 10, wobei das Herstellungsverfahren die folgenden Schritte umfasst:
- Liefern eines Substrats (100) aus einem ersten Halbleitermaterial (10), welches einen ersten Typ Leitfähigkeit aufweist, wobei das Substrat (100) eine erste und eine zweite Seite (110, 120) aufweist,
- Ausbilden eines ersten elektrischen Kontakts (30) auf der ersten Seite (110),
- Bilden einer Mehrzahl von Mikro- oder Nanostrukturen (200) auf der zweiten Seite (120), wobei jede der Mikro- oder Nanostrukturen (200) ein erstes und ein zweites Ende (210, 220) aufweist, wobei jedes der ersten Enden (210) mit der zweiten Seite (120) verbunden ist, wobei jede der Mikro- oder Nanostrukturen (200) wenigstens einen Abschnitt aufweist, der aus einem zweiten Halbleitermaterial (20) ausgebildet ist, welches durch die Wirkung eines Dotierungsmaterials (450) eine Leitfähigkeit eines zweiten Typs aufweist oder aufweisen kann, um einen zweiten Teil (1b) der Halbleiterstruktur (1) mit dem Substrat (100) zu bilden und/oder wobei ein anderer Abschnitt jeder der Mikro- oder Nanostrukturen (200) einen zweiten Teil (1a) der Halbleiterstruktur (1) bildet, oder wobei jede Mikro- oder Nanostruktur (200) den ersten Leitfähigkeitstyp aufweist und wenigstens teilweise einen zweiten Teil (1a) der Halbleiterstruktur (1) bildet,
- Bilden eines Polarisationsmittels, welches dafür ausgebildet ist, wenigstens einen Teil (1a, 1b) aus erstem und zweitem Teil (1a, 1b) zu polarisieren, wobei das Polarisationsmittel derart angeordnet ist, dass seine Polarisation eine Inversion vom Trägertyp in dem Teil (1a, 1b) bewirkt,
- wenn jede Mikro- oder Nanostruktur (200) den ersten Leitfähigkeitstyp aufweist und wenigstens teilweise den zweiten Teil (1a) bildet, Ablagern eines zweiten Halbleitermaterials (20), um den ersten Teil (1b) zu bilden,
- Ausbilden eines zweiten elektrischen Kontakts (40) in Kontakt mit dem zweiten Halbleitermaterial (20),
wobei ein Teil der Mikro- oder Nanostruktur (200) und die zweite Seite (110) den Teil aus erstem und zweiten Teil (1a, 1b) bilden, für den das Injektionsmittel eine Anordnung aufweist, um durch seine Polarisation durch Injektion von Majoritätsträgern des anderen Teils (1b, 1a) in den Teil (1a, 1b) eine Inversion vom Trägertyp in dem Teil (1a, 1b) zu bewirken.

12. Herstellungsverfahren nach Anspruch 11, wobei das Herstellungsverfahren ein Herstellungsverfahren für eine Halbleiterstruktur (1) nach Anspruch 2 oder einem der Ansprüche 3 bis 12 in Kombination mit Anspruch 2 ist, wobei der Schritt darin besteht, ein Polarisationsmittel zu bilden, umfassend die folgenden Schritte:
- Aufbringen einer Isolierschicht (310) auf die Bereiche (121) der von den Mikro- oder Nanostrukturen (200) freigelassenen zweiten Seite (120) und auf wenigstens einen Abschnitt jeder Mikro- oder Nanostruktur (200),
- Aufbringen einer leitenden Schicht (320) auf die Isolierschicht (310).

13. Herstellungsverfahren nach Anspruch 11 oder 12, bei welchem das Herstellungsverfahren nach dem Schritt des Bildens eines Polarisationsmittels und vor dem Schritt des Ausbildens des zweiten elektrischen Kontakts unter anderem die folgenden Schritte umfasst:
- Weglassen des Teils der Isolierschicht (310) und der leitenden Schicht (320) auf jeder der Mikro- oder Nanostrukturen an deren zweitem Ende (220) und wenigstens am Umfang (230) nahe des zweiten Endes (220) auf jeder der Mikro- oder Nanostrukturen (200),
- Aufbringen eines Füllmaterials (400), so dass der Raum zwischen den Mikro- oder Nanostrukturen (200) wenigstens teilweise gefüllt ist und jede der Mikro- oder Nanostrukturen (200) wenigstens einen bedeckten Abschnitt aufweist.

## Claims

1. Semiconductor structure (1) for emitting light comprising:
- a substrate (100) made of a first semi-conductor material (10) having a first type of conductivity, the substrate (100) having a first and a second face (110, 120),
- a first electrical contact (30) on the first face (110),
- at least one second semiconductor material (20), having a second type of conductivity forming a first portion (1b) of the semiconductor structure (1) and in electrical contact with a second portion (1a) of the semiconductor structure (1) having the first conductivity so as to form a junction (50),
- a second electrical contact (40) electrically connected with the second semiconductor material (20),
- a polarization means suitable for polarizing at least one portion (1a, 1b) of the semiconductor structure among the first and the second portion (1a, 1b), the polarization means being laid out so that its polarization leads to an inversion of the type of carriers in said portion (1a, 1b) by injection into said portion (1a, 1b) of majority carriers of the other portion (1b, 1a), so as to move the junction in said portion (1a, 1b),
the semiconductor structure (1) further comprising:
- a plurality of micro- or nano-structures (200) each having a first and a second end (210, 220), each of the first ends (210) being connected to the second face (120), each micro- or nano- structure (200) comprising at least one portion made from the second semiconductor material (20) so as to form the first portion (1b), or each micro- or nano- structure (200) having the first type of conductivity, the second end (220) contacting the second semiconductor material (20) so as to form the junction (50),
the semiconductor structure (1) being **characterized in that** a portion of said micro- or nano-structure (200) and the second face (110) formed the portion, from the first and the second portion (1a, 1b), for which the polarization means is arranged for leading, by its polarization, to an inversion of the type of carriers in said portion (1a, 1b) by injection into said portion (1a, 1b) of majority carriers of the other portion (1b, 1a).

2. Semiconductor structure (1) according to claim 1, wherein the polarization means comprise an insulator layer (310) contacting the portion (1a, 1b) of the semiconductor structure (1) to be polarized and a conductor layer (320) on said insulator layer (310).

3. Semiconductor structure (1) according to claim 2, wherein the insulator layer (310) is contacting the zones (121) of the second face (120) left free by the micro- or nano- structures (200) and on at least one portion of each micro- or nano-structure (200).

4. Semiconductor structure (1) according to any of the preceding claims, wherein each micro or nano- structure (200) is a semiconductor nanowire.

5. Semiconductor structure (1) according to any of the preceding claims, wherein each micro- or nano- structure (200) has a conductivity of the same type as that of the first semi-conductor material (10) so as to form the second portion (1a), the second end (220) of each of the micro- or nano- structures (200) contacting the second semiconductor material (20).

6. Semiconductor structure (1) according to any of claims 1 to 4, wherein each micro or nano-structure (200) has:
- a first portion (250) comprising the first end (210), and having a conductivity of the same type as that of the first semi-conductor material (10) so as to form the second portion (1a), and
- a second portion (260) comprising the second end (220), and being made from the second semiconductor material (20) so as to form the first portion (1b).

7. Semiconductor structure (1) according to claim 4, wherein at least one portion (200, 250, 260) of each nanowire (200) comprises a conformation of the "core-shell" type, in other words that the portion of the nanowire is constituted of at least two semiconductor materials (60, 65), one (60), known as core material, forming the centre of said portion (200, 250, 260) of the nanowire (200) and the other (65), known as shell material, surrounding the core material (60) so as to form the exterior contour of the portion (200, 250, 260) of nanowire (200).

8. Semiconductor structure (1) according to claim 6 in combination with claim 7, wherein each nanowire (200) has a single portion (250, 260) of nanowire comprising a "core-shell" conformation, said portion (250, 260) of nanowire being a portion (250, 260) selected from the group comprising the first portion (250) and the second portion (260).

9. Semiconductor structure (1) according to any of the preceding claims, wherein the portion (1a, 1b) of the first and of the second portion (1a, 1b) having a conductivity in which the majority carriers are electrons is made of a semiconductor material having an n type doping, said semiconductor material being preferentially selected from the group comprising zinc oxide (ZnO), zinc manganese oxide (ZnMgO), gallium nitride (GaN), and aluminium gallium nitride (AlGaN).

10. Semiconductor structure (1) according to any of the preceding claims, wherein the portion (1a, 1b) of the first and of the second portion (1a, 1b) having a conductivity in which majority carriers are holes is made of a semiconductor material having a p type doping, said semiconductor material being preferentially selected from the group comprising gallium nitride (GaN), zinc selenide (ZnSe) and zinc telluride (ZnTe).

11. Method for manufacturing a semiconductor structure (1) according to any of claims 1 to 10, said method for manufacturing comprising the steps consisting in:
- providing a substrate (100) made of a first semi-conductor material (10) having a first type of conductivity, said substrate (100) having a first and a second face (110, 120),
- forming a first electrical contact (30) on the first face (110),
- forming a plurality of micro- or nano-structures (200) on the second face (120), each of the micro- or nano- structures (200) having a first and a second end (210, 220) with each of the first ends (210) connected to the second face (120), each micro- or nano- structure (200) comprising at least one portion made of a second semiconductor material (20) having, or able to have by the action of a doping material (450), a conductivity of a second type so as to form a first portion (1b) of the semiconductor structure (1) with the substrate (100) and/or another portion of each of the micro- or nano- structures (200) forming a second portion (1a) of the semiconductor structure (1), or each micro- or nano- structure (200) having the first type of conductivity and forming at least partially a second portion (1a) of the semiconductor structure (1),
- forming a polarization means suitable for polarizing at least a portion (1a, 1b) among the first and the second portion (1a, 1b), the polarization means being laid out so that its polarization leads to an inversion of the type of carriers in said portion (1a, 1b),
- depositing, if each micro- or nano-structure (200) has the first type of conductivity and forms at least partially the second portion (1a), a second semiconductor material (20) so as to form the first portion (1b),
- forming a second electrical contact (40) contacting the second semiconductor material (20),
wherein a portion of said micro- or nano-structure (200) and the second face (110) formed the portion, from the first and the second portion (1a, 1b), for which the polarization means is arranged for leading, by its polarization, to an inversion of the type of carriers in said portion (1a, 1b) by injection into said portion (1a, 1b) of majority carriers of the other portion (1b, 1a).

12. Method for manufacturing according to claim 11 wherein the method for manufacturing is a method for manufacturing a semiconductor structure (1) according to claim 2 or one of claims 3 to 16 in combination with claim 2, the step consisting in forming a polarization means comprising the steps consisting in:
- depositing an insulator layer (310) on the zones (121) of the second face (120) left free by the micro- or nano- structures (200) and on at least one portion of each micro- or nano- structure (200),
- depositing on the conductor layer (320) the insulator layer (310).

13. Method for manufacturing according to claim 11 or 12, wherein the method for manufacturing comprises after the step consisting in forming a polarization means and before the step consisting in forming the second electrical contact, the steps moreover consisting in:
- eliminating the part of the insulator layer (310) and of the conductor layer (320) present on each of the micro- or nano- structures at the level of their second end (220) and at least at the level of the circumference (230) near to the second end (220) on each of the micro- or nano- structures (200),
- depositing a filling material (400) so that the space between the micro- or nano- structures (200) is at least partially filled and that each of the micro- or nano- structures (200) has at least one covered portion.
